# EUROPÄISCHE PATENTSCHRIFT

(11) **EP 1 662 266 B1**
(45) Veröffentlichungstag und Bekanntmachung des Hinweises auf die Patenterteilung: **01.09.2010**
(21) Anmeldenummer: 05025082.8
(22) Anmeldetag: 16.11.2005
(51) Int. Cl.: G01R 31/28

(54) **Positionierungsvorrichtung und Verfahren zu deren Herstellung**
Positioning device and method for its production
Dispositif de positionnement et procédé destiné à sa fabrication

(30) Priorität: 30.11.2004 DE 102004057733
(43) Veröffentlichungstag der Anmeldung: 31.05.2006
(73) Patentinhaber: Rohde & Schwarz Messgerätebau GmbH, 87700 Memmingen (DE)
(72) Erfinder: Reisinger, Hans-Georg, 89257 Illertissen (DE)
(74) Vertreter: Körfer, Thomas

(56) Entgegenhaltungen:
- WO-A-03/005045
- DE-U1- 8 911 411
- US-A- 5 823 737
- US-A- 6 056 499

## Beschreibung

Die Erfindung betrifft eine Positionierungsvorrichtung zur Positionierung eines Prüflings relativ zu einem Prüfmittel nach der Gattung des Anspruchs 1.

Die Druckschrift DE 27 50 492 A1 beschreibt eine Prüfaufnahme für plattenförmige Baugruppen mit einem Tragrahmen, einer schwenkbaren Führung zur Aufnahme des Prüflings, einem auswechselbaren Adapter, einer austauschbaren Kassette und einem schwenkbaren Buchsenfeld. Auf der Vorderseite des Tragrahmens ist eine schwenkbare Führung mit einer oberen und einer unteren Führungsschiene vorgesehen, die die zu prüfende Baugruppe und einen austauschbarer Adapter, in den die zu prüfende Baugruppe einsteckbar ist, aufnimmt. Hinter der schwenkbaren Führung im Tragrahmen ist eine austauschbare Kassette mit Prüfspitzen zum Kontaktieren bestimmter Punkte der Baugruppe beweglich gehaltert. Des Weiteren ist auf der Rückseite des Tragrahmens ein schwenkbares Buchsenfeld für Verbindungs-, Trenn- und Prüfstecker angeordnet.

Dokument US 6,056,499 beschreibt eine Effektor-Baugruppe, die dafür geeignet ist, Testautomaten zwischen einem Lager und einer Testumgebung zu transportieren. Die Effektor-Baugruppe umfasst einen drehbaren Rahmen, ein Paar Lastarme, die auseinander gezogen oder zusammen geschoben werden können und ein Paar Greifelemente für einen Hebevorgang. Der Betrieb der Effektor-Baugruppe ist dadurch gewährleistet, dass die Baugruppe in die Nähe eines ersten Ortes geschoben wird, wobei die verlängerten Lastarme so betätigt werden, dass sie gegenüberliegende Griffe umfassen.

Die US 5 823 737 A zeigt eine Vorrichtung zum Heben, Tragen und Positionieren von Prüfmittel. Die Vorrichtung umfasst zwei gegenüberliegende bewegliche Arme mit einem Aufnahmemechanismus für die Griffe der Prüfmittel sowie einem feststehend Stützelement. Die beweglichen Arme sind über eine Anordnung an der Vorder- und Rückseite des Stützelements mit dem Stützelement verbunden und in vertikale und horizontale Richtung bewegbar. Die Vorrichtung ist auf einem unteren Rahmen mit Rollen beweglich montiert.

Aus der Druckschrift DE 89 11 411 U1 ist ein Prüfadapter für Baugruppen der elektrischen Nachrichtentechnik bekannt, der aus einem Aufnahmerahmen für den Prüfling und aus einem verlängerten, in eine Baugruppenaufnahme einsteckbaren rückwärtigen Teil besteht. Der Aufnahmerahmen besteht aus einem u-förmig gebogenen Blechteil, bei dem seitlich Führungsprägungen für den Prüfling in das Blech eingedrückt sind und bei dem der rückwärtige, eigentliche Prüfadapter, der aus einer Leiterplatte besteht, in die rückseitig gleichartig fluchtenden Prägungen des Aufnahmerahmens einsteckbar ist. Der Prüfadapter ist dort über Winkel mit dem Aufnahmerahmen verbunden und zumindest auf der Leiterseite, durch ein wannenförmiges, isoliertes Teil, das gleichzeitig der versteifung dient, abgedeckt.

Der Nachteil des aus der obigen Druckschrift bekannten Prüfadapters besteht darin, dass es keinen Freiheitsgrad für die Positionierung des Prüfadapters relativ zu einem Prüfmittel oder zu einem Gesamtsystem, in dem der Prüfling konstruktionsmäßig vorgesehen ist, gibt. Der Prüfadapter kann nur so positioniert werden, dass er in das Prüfmittel oder in das zu prüfende Gesamtsystem eingeschoben wird. Dabei ist es notwendig, daß Geometrie und Stecker des Prüfadapters so gestaltet sind, dass eine stabile Verbindung von Prüfling und Gesamtsystem bzw. Prüfmittel sichergestellt ist. Die Anwendung des in der obengenannten Druckschrift beschriebenen Prüfadapters ist somit auf das Prüfmittel bzw. auf das Gesamtsystem festgelegt und nicht flexibel.

Der Erfindung liegt die Aufgabe zugrunde, eine Positionierungsvorrichtung, welche kostengünstig herstellbar ist und in welcher der Prüfling flexibel positionierbar ist, und ein Verfahren zu dessen Herstellung zu schaffen. Die Aufgabe wird durch die Merkmale des Anspruchs 1 bzw. des Anspruchs 21 gelöst. Vorteilhafte Weiterbildungen sind in den Unteransprüchen angegeben. Die erfindungsgemäße Positionierungsvorrichtung weist dabei mehrere Freiheitsgrade zur Positionierung des Prüflings auf.

Des weiteren ist es vorteilhaft, dass die Positionierungsvorrichtung verschiedene Prüflinge aufnehmen kann. Das bedeutet, dass die Prüflinge sich bezüglich ihrer Geometrie unterscheiden können. Die erfindungsgemäße Positionierungseinrichtung ist vorteilhafterweise so konstruiert, dass es einfach ist, den Prüfling auszutauschen und einen neuen Prüfling, der sich vom auszutauschenden Prüfling hinsichtlich der Länge, Höhe oder Breite unterscheidet, in einen Aufnahmerahmen, der von zwei Aufnahmearmen und einer Querstrebe gebildet ist, einzusetzen.

Eine Variation der Länge des Aufnahmerahmens ist dadurch zu erreichen, dass die Querstrebe, die die Länge des aufzunehmenden Prüflings definiert, gegen eine längere oder kürzere Querstrebe ausgetauscht wird. Vorteilhafterweise kann die Querstrebe leicht ausgetauscht werden, da die Konstruktion der Positionierungsvorrichtung keine Verschraubung der Querstrebe an den beiden Drehlagern vorsieht. Der Vorteil besteht darin, dass die neue, eingewechselte Querstrebe keine Gewindebohrung aufweisen muss, da die Querstrebe an den beiden Drehlagern verklemmt ist. Dies erleichtert sowohl die Demontage als auch die Montage des Aufnahmerahmens, da die verklemmte Querstrebe schnell und leicht auszubauen ist.

Weiter ist von Vorteil, dass verschieden lange Querstreben nicht mehr mit Gewindebohrungen versehen werden müssen, um den Aufnahmerahmen an eine geänderte Geometrie des Prüflings anzupassen. Dies reduziert den Aufwand und trägt zur Kostenminderung bei der Bereitstellung von Prüfmitteln bei.

Ein weiterer Vorteil der Erfindung besteht im kostengünstigen Herstellungsverfahren für die Positionierungsvorrichtung. Die Positionierungsvorrichtung ist weitgehend aus einem plattenförmigen Blechrohling gefertigt, wobei CAM zum Einsatz kommen kann und die Einzelteile der Positionierungsvorrichtung nach dem Laserschneiden oder Wasserstrahlschneiden ein plattenförmiges Gesamtstück bilden, das an den dafür vorgesehenen Trennstellen gratlos zertrennt werden kann. Dies hat den Vorteil, dass die Positionierungsvorrichtung schnell produziert werden kann, was eine gute Verfügbarkeit dieses Teils sicherstellt und Prozesse in der Prüfmittelbereitstellung beschleunigt.

Ein weiterer Vorteil im Herstellungsverfahren für die genannte erfindungsgemäße Positionierungsvorrichtung ist die Optimierung der Schneidabfälle. Schneidabfälle verzögerten bisher das Laserschneiden. Diese Schneidabfälle werden nun gleichzeitig mit dem Trennen der Teile entfernt, was die Herstellung einiger Komponenten der erfindungsgemäßen Positionierungsvorrichtung weiter vereinfacht.

Ausführungsbeispiele der Erfindung werden nachfolgend unter Bezugnahme auf die Zeichnung näher beschrieben. In der Zeichnung zeigen:
- Fig. 1: eine perspektivische Gesamtdarstellung der erfindungsgemäßen Positionierungsvorrichtung;
- Fig. 1A: eine perspektivische Darstellung einer Drehlagerung der erfindungsgemäßen Positionierungsvorrichtung mit Rastzähnen und Rastnuten;
- Fig. 1B: eine Profilansicht eines Rastzahns einer erfindungsgemäßen Positionierungsvorrichtung;
- Fig. 2: eine Seitenansicht der erfindungsgemäßen Positionierungsvorrichtung;
- Fig. 3: eine Gesamtdarstellung der erfindungsgemäßen Positionierungsvorrichtung in der Draufsicht;
- Fig. 4: einen Schnitt durch die erfindungsgemäße Positionierungsvorrichtung;
- Fig. 5: eine Draufsicht auf das plattenförmige Gesamtteil einer erfindungsgemäßen Positionierungsvorrichtung nach dem Laserschneiden;
- Fig. 6: eine perspektivische Darstellung des aufgefalteten Gesamtteils;
- Fig.7: eine Draufsicht auf das aufgefaltete Gesamtteil einer erfindungsgemäßen Positionierungsvorrichtung;
- Fig.8: eine Draufsicht auf das plattenförmige Gesamtteil eines Ausführungsbeispiels einer erfindungsgemäßen Positionierungsvorrichtung nach dem Laserschneiden und
- Fig.9: eine schematische Darstellung der Positionierungsvorrichtung mit einem fixierten Prüfling und ein damit verbundenes Prüfgerät.

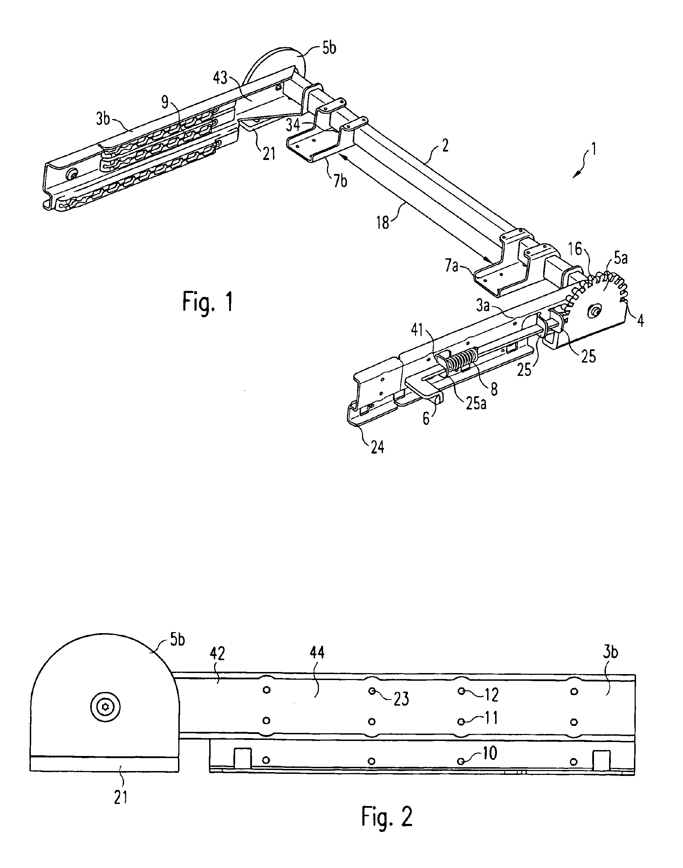

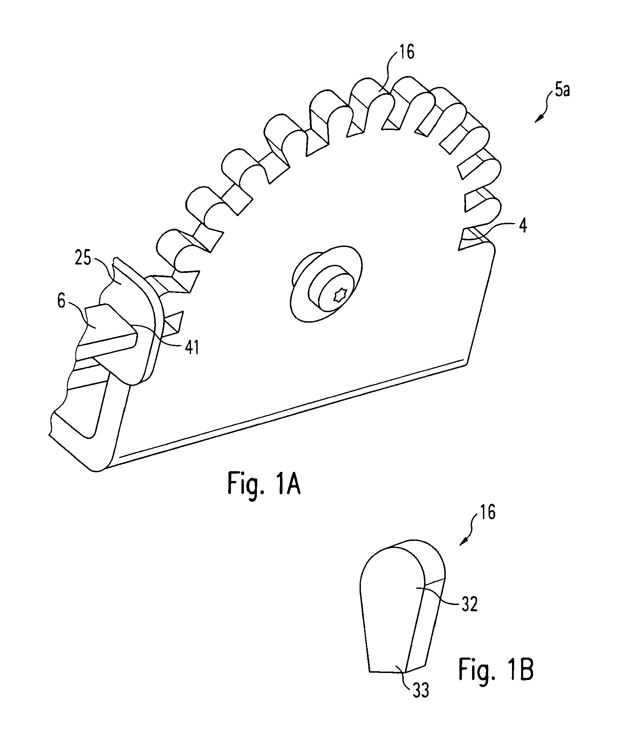

Fig. 1 zeigt eine perspektivische Gesamtdarstellung der erfindungsgemäßen Positionierungsvorrichtung 1 zur Positionierung eines Prüflings 36 relativ zu einem Prüfmittel 50 mit zwei Aufnahmearmen 3a, 3b zur Aufnahme des Prüflings 36, zwei Drehlagerungen 5a, 5b, einer an beiden Drehlagerungen 5a, 5b fixierten Querstrebe 2 und zwei an der Querstrebe 2 befestigten Halterungen 7a, 7b, die zwischen den Drehlagerungen 5a, 5b vorgesehen sind. Halterungen 7a , 7b und Aufnahmearme 3a, 3b werden aus einem Blechteil gefertigt. Die Querschnitte 24 der beiden Aufnahmearme 3a, 3b sind s-förmig, wobei die s-Formen der Querschnitte der Aufnahmearme 3a, 3b spiegelbildlich zueinander ausgebildet sind.

An einer Außenseite 44 des ersten Aufnahmearmes 3a sind drei Winkelstücke 25, 25a aufgefaltet, die alle jeweils einen Durchstich 41 aufweisen. Der an den Winkelstücken 25, 25a ausgeführte Durchstich 41 dient dazu, einen Raststift 6 mit einer axial angebrachten Feder 8 zu führen und sein vorderes Ende in eine Rastnut 4, die an einer der beiden Drehlagerungen 5a jeweils zwischen zwei Rastzähnen 16 vorgesehen ist, einzurasten. An beiden Innenseiten 43 der Aufnahmearme 3a, 3b sind Aufnahmeschienen 9, die aus Kunststoff hergestellt sein können, vorgesehen, in die ein Prüfling 36 eingeschoben und fixiert werden kann.

Fig. 1A zeigt eine perspektivische Darstellung der mit Rastnuten 4 und Rastzähnen 16 versehenen Drehlagerung 5a. Ein mit einer Federkraft beaufschlagter Raststift 6, der unmittelbar vor der Drehlagerung 5a durch den Durchstich 41 des aufgefalteten Winkelstücks 25 geführt wird, wird in einer Rastnut 4 fixiert. Dadurch, daß dreizehn Rastnuten 4 an der Drehlagerung 5a vorgesehen sind, ergeben sich dreizehn verschiedene Positionen der Aufnahmearme 3a, 3b bezüglich einer Befestigungsvorrichtung 21 für die Drehlagerungen 5a, 5b.

Fig. 1B zeigt eine perspektivische Darstellung eines Rastzahns 16. Der Rastzahn 16 ist an seinem radial äußeren Ende 32 gegenüber seinem radial inneren Ende 33 verbreitert. Der Zweck dieser Form liegt darin, dass der Raststift 6 leichter einrastet, da der Raststift 6 aufgrund seiner Beschaffenheit gut am Rastzahn 16 in die Rastnut 4 abrutschen kann. Die Form der Zähne und ihre Anordnung wurde so gewählt, daß der Abrieb zwischen Raststift 6 und Rastnut 4 der Drehlagerung 5a minimiert wird.

Fig. 2 zeigt eine Seitenansicht einer Außenseite 44 eines Aufnahmearms 3b mit einer der beiden Drehlagerungen 5b. Beide Aufnahmearme 3, 3a weisen in der Seitenwand 42 eine untere Lochreihe 10, eine mittlere Lochreihe 11 und eine obere Lochreihe 12 auf, die jeweils aus vier Löchern 23 bestehen und die dazu dienen, die vorzugsweise aus Kunststoff bestehenden Aufnahmeschienen 9, die den Prüfling 36 in der Positionierungsvorrichtung 1 fixieren, an der Innenseite 43 der Aufnahmearme 3, 3a anzubringen. Für den Prüfling 36 können somit drei verschiedene Höhenpositionen ausgewählt werden.

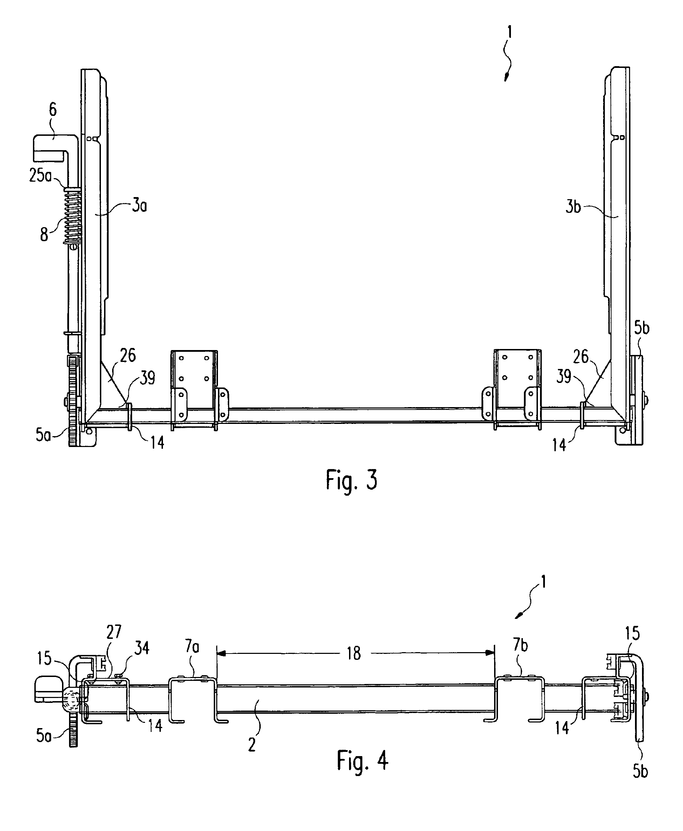

In Fig. 3 ist eine Draufsicht auf die erfindungsgemäße Positionierungsvorrichtung 1 zu sehen. Deutlich erkennbar sind dreieckförmige Verstärkungsbleche 26, die zwischen jeweils einem Aufnahmearm 3a, 3b und der Querstrebe 2, die massiv oder als Hohlprofil ausgebildet sein kann, angebracht sind. An den dreieckförmigen Verstärkungsblechen 26 sind senkrecht dazu jeweils zwei Durchbrüche 14, 15 angebracht, die die Querstrebe 2 aufnehmen und an jeweils einem Aufnahmearm 3a, 3b im Bereich der Drehlagerungen 5a, 5b fixieren. Der zweite Durchbruch 15 ist in dieser Darstellung nicht sichtbar, da er jeweils von dem Aufnahmearm 3a, 3b verdeckt wird.

Der erste Durchbruch 14 ist an einem ersten Ende 39 des Verstärkungsblechs 26 und der zweite Durchbruch 15 ist an einem zweiten, von jeweils einem Aufnahmearm 3a, 3b verdeckten Ende 40 des Verstärkungsblechs 26 für die Aufnahme der Querstrebe 2 vorgesehen. An beiden Durchbrüchen 14, 15 ist jeweils eine kleine - in dieser Darstellung ebenfalls nicht sichtbaren_- Abschrägung 45 vorgesehen. Beim Anziehen der in Fig. 4 dargestellten Klemmschrauben 34 wird das Profil der Querstrebe 2 gegen diese Abschrägungen 45 der Durchbrüche 14, 15 gepreßt, wobei eine stabile und spielfreie Verbindung zwischen der Querstrebe 2 und jeweils einem Aufnahmearm 3a, 3b sichergestellt ist. An dem Aufnahmearm 3a ist an seiner Außenseite 44 der Raststift 6 angebracht, indem er durch an den aufgebogenen Winkelstücken 25, 25a angebrachte Durchstiche 41 geführt wird. Eine axial angebrachte Feder 8, die den Raststift 6 radial umgibt und an einem ersten Winkelstück 25a anliegt, sorgt dafür, dass die Position des Raststifts 6 nach dem Einrasten in eine Rastnut 4 stabil bleibt.

Fig. 4 zeigt einen Schnitt durch die erfindungsgemäße Positionierungsrichtung 1, wobei die Blickrichtung von unten nach oben verläuft. Auf der Querstrebe 2 sind die zwei Halterungen 7a und 7b angebracht, deren Abstand 18 variabel sein kann, und die dazu dienen, eine Steckerleiste aufzunehmen und zu fixieren. Neben den Halterungen 7a und 7b sind die zwei Durchbrüche 14, 15 angebracht, durch die die Querstrebe 2 geführt und an beiden Drehlagerungen 5a, 5b durch Klemmmittel fixiert wird. Die Klemmwirkung wird durch zwei Klemmschrauben 34 erzielt, die ein Verbindungsblech 27 der beiden Durchbrüche 14, 15 an die Querstrebe 2 drücken.
Fig. 4 zeigt, dass die beiden Durchbrüche 14, 15 und das Verbindungsblech 27 im Ausführungsbeispiel aus einem Stück gefertigt sind.

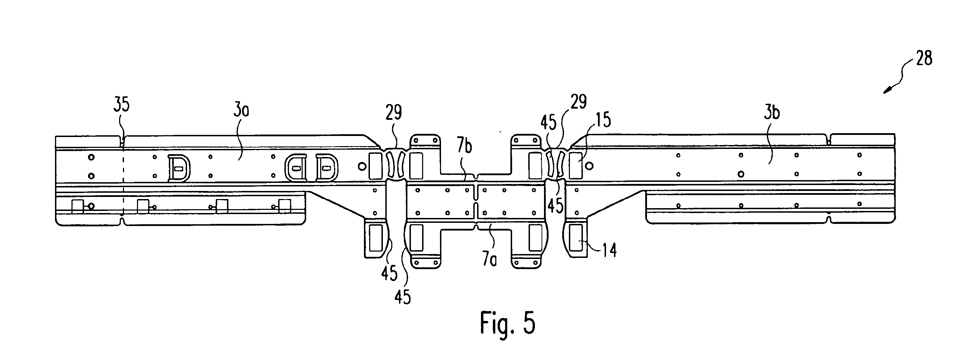

Fig. 5 zeigt ein plattenförmiges Gesamtteil 28 als Halbzeug aus Blech, das die Einzelteile Aufnahmearme 3a, 3b und Halterungen 7a, 7b für Stecker mit verschiedenen Längen enthält. Das plattenförmige Gesamtteil 28 aus Blech wird an den vorgesehenen Trennstellen 29 in die Einzelteile Aufnahmearme 3a, 3b und Halterungen 7a, 7b der Positionierungsvorrichtung 1 zerlegt, wobei die Trennung an den dafür vorgesehenen Trennstellen 29 gratlos erfolgt.

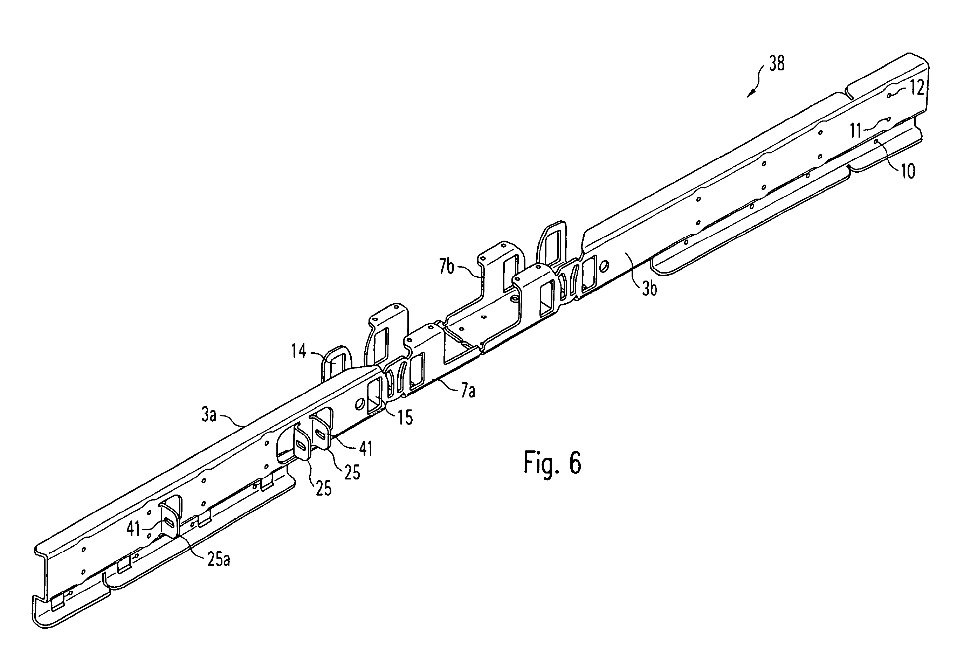

Fig. 6 zeigt ein gebogenes Blechteil 38, das die Einzelteile Aufnahmearme 3a, 3b und Halterungen 7a, 7b enthält im aufgefalteten Zustand. Am Aufnahmearm 3a sind drei aufgefaltete Winkelstücke 25, 25a angebracht, die jeweils einen Durchstich 41 aufweisen, der den Raststift 6 führt. Am vorderen Ende der Aufnahmearme 3a, 3b ist deutlich zu erkennen, daß die Durchbrüche 14, 15 zur Klemmfixierung der Querstrebe 2 mittels Klemmschrauben 34 parallel zueinander angeordnet sind und aus einem Blechteil bestehen. Beide Aufnahmearme 3a, 3b weisen drei Reihen 10, 11, 12 von parallelen Löchern 23 auf, die zur Befestigung der Aufnahmeschiene 9 für den Prüfling 36 dienen.

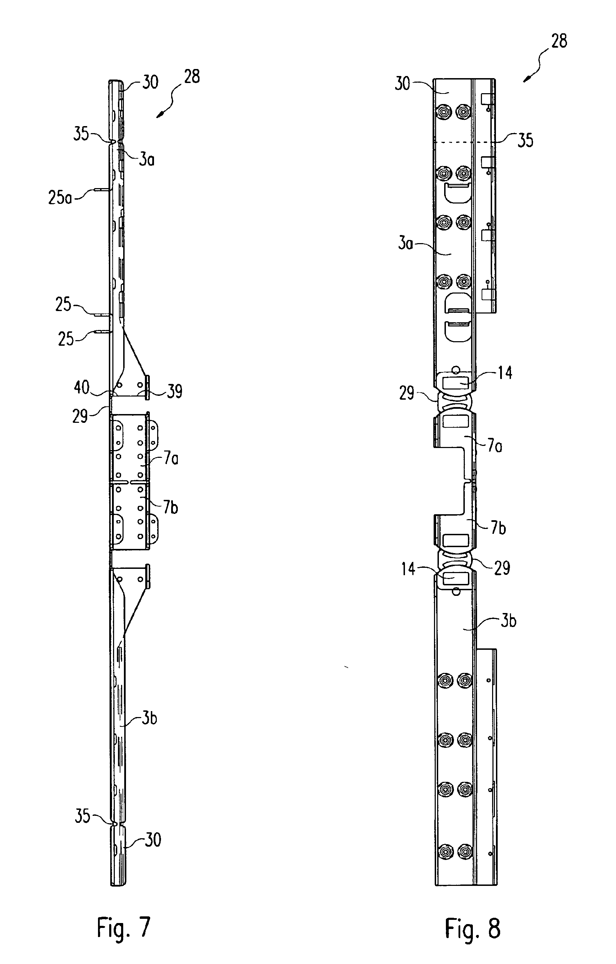

Fig. 7 zeigt eine erfindungsgemäße Positionierungsvorrichtung 1, die als plattenförmiges Gesamtteil 28 aus Blech vorliegt und die Einzelteile Aufnahmearme 3a, 3b sowie zwei Halterungen 7a, 7b enthält. An jedem Aufnahmearm 3a, 3b ist ein Verlängerungsstück 30 vorgesehen, das an einer dafür vorgesehenen Sollbruchstelle 35 abtrennbar ist, um eine Aufnahmeschiene 9 für einen kürzeren Prüfling 36 an den Innenseiten der Aufnahmearme 3a, 3b zu befestigen.

Fig. 8 zeigt eine Draufsicht auf das plattenförmige Gesamtteil 28 eines Ausführungsbeispiels einer erfindungsgemäßen Positionierungsvorrichtung 1 nach dem Laserschneiden, wobei nur ein Durchbruch zur Fixierung der Querstrebe 2 vorgesehen ist. Außerdem ist kein Verbindungsblech vorgesehen, das zur Unterstützung der Fixierung der Querstrebe 2 an den beiden Drehlagern 5a, 5b dient.

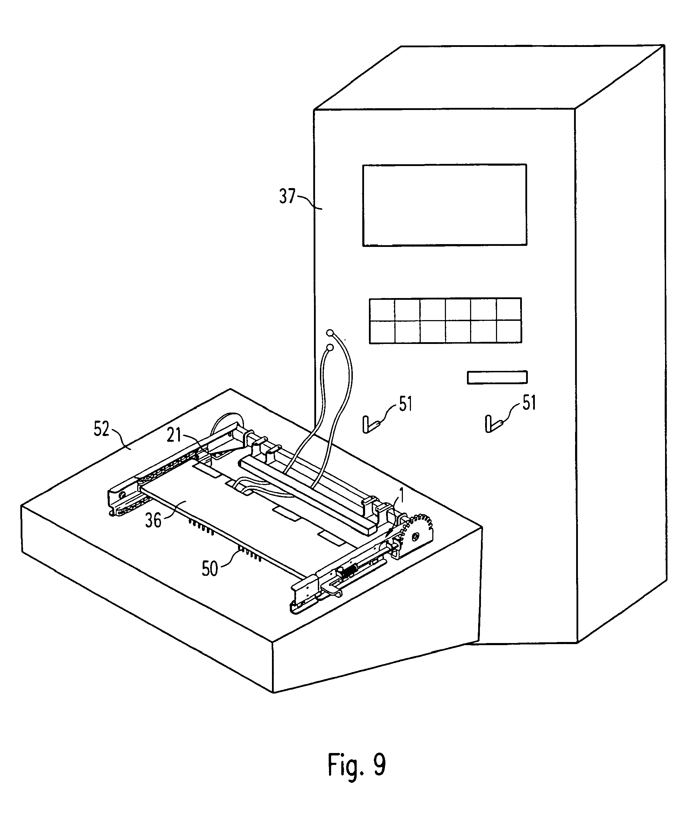

Fig. 9 zeigt eine schematische Darstellung der Positionierungsvorrichtung 1 mit einem fixierten Prüfling 36 und ein Prüfmittel 50 in Form von Adapternadeln. Der Prüfling 36 wird in die an beiden Aufnahmearmen 3a, 3b vorgesehenen Aufnahmeschienen 9 eingeschoben und fixiert. Die erfindungsgemäße Positionierungsvorrichtung 1 ist auf einem Pult 52 mittels der dafür vorgesehenen Befestigungsvorrichtung 21 fixiert, das die Prüfmittel 50 z. B. in Form von Adapternadeln enthält. Das Pult 52 ist an einem Prüfgerät 37 über Aufnahmehaken 51, die in entsprechende Gegenstücke des Pults 52 eingreifen, fixierbar.

Beim CAD und CAM gestützten Herstellungsverfahren für eine erfindungsgemäße Positionierungsvorrichtung 1 werden beide Aufnahmearme 3a, 3b und beide Halterungen 7a, 7b aus einem plattenförmigen Blech-Rohmaterial gefertigt. Aufnahmearme 3a, 3b und Halterungen 7a, 7b der Positionierungsvorrichtung 1 sind in einem plattenförmigen Gesamtteil 28, das durch Laserschneiden aus dem plattenförmigen Blech-Rohmaterial hervorgeht, enthalten und an Trennstellen 29 miteinander verbunden, wobei nach dem Laserschneiden Löcher 23 für die Befestigung der Aufnahmeschienen 9 eingestanzt oder eingebohrt werden. Das plattenförmige Gesamtteil 28 wird nach dem Stanzen der Löcher 23 für die Aufnahmeschienen 9 an den vorgesehenen Trennstellen 29 in die Einzelteile Aufnahmearme 3a, 3b und Halterungen 7a, 7b der Positionierungsvorrichtung 1 zerlegt, wobei die Trennung an den vorgesehenen Trennstellen 29 gratlos erfolgt.

Anschließend werden Aufnahmearme 3a, 3b und Halterungen 7a und 7b der Positionierungsvorrichtung 1 in ihre endgültige Form aufgefaltet. An den aufgefalteten Aufnahmearmen 3a, 3b werden die Aufnahmeschienen 9 jeweils an mindestens zwei in einer Reihe liegenden Löchern 23 in der Seitenwand 42 der Aufnahmearme 3a, 3b an der Innenseite 43 der Seitenwand 42 befestigt. Die Halterungen 7a, 7b werden auf die Querstrebe 2, die aus massiven Material gefertigt sein kann oder ein Hohlprofil aufweisen kann, geschoben. Ihr Abstand 18 kann so eingestellt werden, daß ein Stecker, der beispielsweise für eine elektrische Kontaktierung des Prüflings 36 oder einen Datenfluß zum Prüfling 36 vorgesehen ist von den Halterungen 7a, 7b aufgenommen und fixiert wird. Die mit den beiden Halterungen 7a, 7b versehene Querstrebe 2 wird durch die an den Aufnahmearmen 3a, 3b und dem Verbindungsblech 26 vorgesehenen Durchbrüche 14, 15 geschoben und mit Klemmschrauben 34 im Bereich der Drehlagerungen 5a, 5b verklemmt.

Die Erfindung ist nicht auf die dargestellten Ausführungsbeispiele beschränkt. Insbesondere sind beliebige Kombinationen der verschiedenen Merkmale möglich. Statt Laserschneiden kann auch eine andere Schneidtechnik, z. B. Wasserstrahlschneiden, zum Einsatz kommen.

## Patentansprüche

1. Positionierungsvorrichtung (1) zur Positionierung eines Prüflings (36) bezüglich eines Prüfmittels (50) mit einer Querstrebe (2), zwei Drehlagerungen (5a, 5b) für die Querstrebe (2) und mit zwei Aufnahmearmen (3a, 3b) zur Aufnahme des Prüflings (36),
**dadurch gekennzeichnet,**
**dass** die Aufnahmearme (3a, 3b) aus einem gebogenen Blechteil (38) bestehen und dass verschiedene Positionen der Aufnahmearme (3a, 3b) bezüglich einer Befestigungsvorrichtung (21) für die Drehlagerungen (5a, 5b) vorgesehen sind,
**dass** die Querstrebe (2) an beiden Drehlagerungen (5a, 5b) fixiert ist, und
**dass** die Aufnahmearme (3a, 3b) zumindest einen Durchbruch (14, 15) aufweisen und dass die in den zumindest einen Durchbruch (14, 15) eingeschobene Querstrebe (2) an beiden Drehlagerungen (5, 5a) durch Klemmmittel fixiert ist.

2. Positionierungsvorrichtung nach Anspruch 1,
**dadurch gekennzeichnet,**
**dass** das Klemmmittel Klemmschrauben (34) sind.

3. Positionierungsvorrichtung nach Ansprüche 1 oder 2,
**dadurch gekennzeichnet,**
**dass** die Querstrebe (2) massiv ist.

4. Positionierungsvorrichtung nach Anspruch 1 oder 2,
**dadurch gekennzeichnet,**
**dass** die Querstrebe (2) als Hohlprofil ausgebildet ist.

5. Positionierungsvorrichtung nach einem der Ansprüche 1 bis 4,
**dadurch gekennzeichnet,**
**dass** zwischen jeweils einem Aufnahmearm (3a, 3b) und der Querstrebe (2) ein Verstärkungsblech (26) vorgesehen ist.

6. Positionierungsvorrichtung nach Anspruch 5,
**dadurch gekennzeichnet,**
**dass** das Verstärkungsblech (26) dreieckförmig zwischen jeweils einem Aufnahmearm (3a, 3b) und der Querstrebe (2) ausgebildet ist, wobei an einem ersten Ende (39) des dreieckförmigen Verstärkungsbleches (26) ein erster Durchbruch (14) für die Aufnahme der Querstrebe (2) vorgesehen ist.

7. Positionierungsvorrichtung nach Anspruch 5,
**dadurch gekennzeichnet,**
**dass** an einem zweiten Ende (40) des dreieckförmigen Verstärkungsbleches (26) ein zweiter Durchbruch (15) für die Aufnahme der Querstrebe (2) vorgesehen ist.

8. Positionierungsvorrichtung nach Anspruch 6 und 7,
**dadurch gekennzeichnet,**
**dass** an beiden Durchbrüchen (14, 15) jeweils eine kleine Abschrägung (45) vorgesehen ist.

9. Positionierungsvorrichtung nach einem der Ansprüche 1 bis 8,
**dadurch gekennzeichnet,**
**dass** zwischen den beiden Drehlagerungen (5a, 5b) zwei auf der Querstrebe (2) fixierte Halterungen (7a, 7b) vorgesehen sind.

10. Positionierungsvorrichtung nach Anspruch 9,
**dadurch gekennzeichnet,**
**dass** der Abstand (18) der Halterungen (7a, 7b) variabel ist.

11. Positionierungsvorrichtung nach einem der Ansprüche 1 bis 10,
**dadurch gekennzeichnet,**
**dass** an zumindest einem Drehlager (5a) mindestens zwei Rastnuten (4) mit einem zwischen zwei Rastnuten (4) angeordneten Rastzahn (16) vorgesehen sind.

12. Positionierungsvorrichtung nach Anspruch 11,
**dadurch gekennzeichnet,**
**dass** ein Rastzahn (16) an seinem radial äußeren Ende (32) breiter ist, als an seinem radial inneren Ende (33).

13. Positionierungsvorrichtung nach einem der Ansprüche 1 bis 12,
**dadurch gekennzeichnet,**
**dass** an einer Außenseite (44) des ersten Aufnahmearms (3a) zumindest zwei aufgefaltete Winkelstücke (25, 25a) mit jeweils einem Durchstich (41) vorgesehen sind.

14. Positionierungsvorrichtung nach Anspruch 13,
**dadurch gekennzeichnet,**
**dass** ein Raststift (6) mit einer axial angebrachten Feder (8) in zumindest zwei Durchstichen (41) der zumindest zwei Winkelstücke (25, 25a) an einer Außenseite des Aufnahmearms (3a) vorgesehen ist.

15. Positionierungsvorrichtung nach einem der Ansprüche 1 bis 14,
**dadurch gekennzeichnet,**
**dass** an einer Seitenwand (42) der Aufnahmearme (3a, 3b) zumindest eine Lochreihe (11) bestehend aus mindestens zwei Löchern (23) vorgesehen ist.

16. Positionierungsvorrichtung nach Anspruch 15,
**dadurch gekennzeichnet,**
**dass** zumindest eine an mindestens zwei Löchern (23) einer unteren, mittleren oder oberen Lochreihe (10, 11, 12) befestigte Aufnahmeschiene (9) vorgesehen ist.

17. Positionierungsvorrichtung nach Anspruch 16,
**dadurch gekennzeichnet,**
**dass** die Aufnahmeschiene (9) aus Kunststoff hergestellt ist.

18. Positionierungsvorrichtung nach einem der Ansprüche 1 bis 17,
**dadurch gekennzeichnet,**
**dass** an beiden Aufnahmearmen (3a, 3b) ein Verlängerungsstück (30) angeformt ist.

19. Positionierungsvorrichtung nach einem der Ansprüche 1 bis 18,
**dadurch gekennzeichnet,**
**dass** ein Querschnitt jedes Aufnahmearms (3a, 3b) s-förmig (24) ausgeprägt ist.

20. Positionierungsvorrichtung nach Anspruch 19,
**dadurch gekennzeichnet,**
**dass** die Querschnitte der Aufnahmearme (3a, 3b) spiegelbildlich zueinander ausgebildet sind.

21. Verfahren zur Herstellung einer Positionierungsvorrichtung (1) zur Positionierung eines Prüflings (36) bezüglich eines Prüfmittels (50) mit einer Querstrebe (2), mit zwei Drehlagerungen (5a, 5b) für die Querstrebe (2), auf welcher zwei Halterungen (7a, 7b) fixiert sind und mit zwei Aufnahmearmen (3a, 3b) für den Prüfling (36)
**dadurch gekennzeichnet,**
**dass** die Aufnahmearme (3a, 3b) aus einem gebogenen Blechteil (38) bestehen und dass verschiedene Positionen der Aufnahmearme (3a, 3b) bezüglich einer Befestigungsvorrichtung (21) für die Drehlagerungen (5a, 5b) vorgesehen sind,
**dass** die Querstrebe (2) an beiden Drehlagerungen (5a, 5b) fixiert wird, und
**dass** die Aufnahmearme (3a, 3b) zumindest einen Durchbruch (14, 15) aufweisen und
**dass** die in den zumindest einen Durchbruch (14, 15) eingeschobene Querstrebe (2) an beiden Drehlagerungen (5, 5a) durch Klemmmittel fixiert wird und
**dass** beide Aufnahmearme (3, 3a) und beide Halterungen (7a, 7b) CAD und CAM gestützt aus einem plattenförmigen Blech-Rohmaterial gefertigt werden.

22. Verfahren nach Anspruch 21,
**dadurch gekennzeichnet,**
**dass** die Positioniervorrichtung (1) zwei an der Querstrebe (2) angebrachten Halterungen (7a, 7b) aufweist, dass die Aufnahmearme (3a, 3b) und die Halterungen (7a, 7b) der Positionierungsvorrichtung (1) aus einem plattenförmigen Gesamtteil (28), das durch Schneiden aus dem plattenförmigen Blech-Rohmaterial hervorgeht, hergestellt werden und zunächst noch an Trennstellen (29) mit den Aufnahmearmen (3a, 3b) verbunden sind.

23. Verfahren nach Anspruch 22,
**dadurch gekennzeichnet,**
**dass** Löcher in das plattenförmige Gesamtteil (28) eingestanzt oder eingebohrt werden.

24. Verfahren nach Anspruch 23,
**dadurch gekennzeichnet,**
**dass** das plattenförmige Gesamtteil (28) an den vorgesehenen Trennstellen (29) in die Einzelteile der Positionierungsvorrichtung (1) zerlegt wird, wobei die Trennung an den Trennstellen (29) gratlos erfolgt.

25. Verfahren nach Anspruch 24,
**dadurch gekennzeichnet,**
**dass** die Einzelteile der Positionierungsvorrichtung (1) in ihre endgültige Form aufgefaltet werden.

26. Verfahren nach Anspruch 25,
**dadurch gekennzeichnet,**
**dass** jeweils zumindest eine Aufnahmeschiene (9) an mindestens zwei in einer Reihe liegenden Löchern der Seitenwand (42) an der Innenseite (43) jeweils eines Aufnahmearms (3a, 3b) befestigt wird.

27. Verfahren nach Anspruch 26,
**dadurch gekennzeichnet,**
**dass** zumindest zwei variabel zu beabstandende Halterungen (7a, 7b) auf die gefertigte Querstrebe (2) geschoben werden.

28. Verfahren nach Anspruch 27,
**dadurch gekennzeichnet,**
**dass** die Querstrebe (2) durch die an den Aufnahmearmen (3a, 3b) und dem Verbindungsblech (27) angebrachten Durchbrüche (14, 15) geschoben wird und mit Klemmschrauben (34) im Bereich der Drehlagerungen (5a, 5b) verklemmt wird.

## Claims

1. Positioning device (1) for positioning a sample (36) with reference to a test means (50) having a cross strut (2), two pivot bearings (5a, 5b) for the cross strut (2), and having two holding arms (3a, 3b) for holding the sample (36), **characterized in that** the holding arms (3a, 3b) consist of a bent sheet-metal part (38), and **in that** various positions of the holding arms (3a, 3b) are provided with reference to a fastening device (21) for the pivot bearings (5a, 5b), **in that** the cross strut (2) is fixed on both pivot bearings (5a, 5b), and **in that** the holding arms (3a, 3b) have at least one cutout (14, 15), and **in that** the cross strut (2) pushed into the at least one cutout (14, 15) is fixed on both pivot bearings (5, 5a) by clamping means.

2. Positioning device according to Claim 1, **characterized in that** the clamping means are clamping screws (34).

3. Positioning device according to Claim 1 or 2, **characterized in that** the cross strut (2) is solid.

4. Positioning device according to Claim 1 or 2, **characterized in that** the cross strut (2) is designed as a hollow profile.

5. Positioning device according to one of Claims 1 to 4, **characterized in that** a reinforcing plate (26) is provided between a respective holding arm (3a, 3b) and the cross strut (2).

6. Positioning device according to Claim 5, **characterized in that** the reinforcing plate (26) is designed in the shape of a triangle between a respective holding arm (3a, 3b) and the cross strut (2), a first cutout (14) for holding the cross strut (2) being provided at a first end (39) of the triangular reinforcing plate (26).

7. Positioning device according to Claim 5, **characterized in that** a second cutout (15) for holding the cross strut (2) is provided at a second end (40) of the triangular reinforcing plate (26).

8. Positioning device according to Claims 6 and 7, **characterized in that** a respective small bevel (45) is provided on both cutouts (14, 15).

9. Positioning device according to one of Claims 1 to 8, **characterized in that** two holders (7a, 7b) fixed on the cross strut (2) are provided between the two pivot bearings (5a, 5b).

10. Positioning device according to Claim 9, **characterized in that** the spacing (18) of the holders (7a, 7b) is variable.

11. Positioning device according to one of Claims 1 to 10, **characterized in that** at least two latching grooves (4) on at least one pivot bearing (5a) are provided with a latching tooth (16) arranged between two latching grooves (4).

12. Positioning device according to Claim 11, **characterized in that** a latching tooth (16) is wider at its radially outer end (33) than at its radially inner end (33).

13. Positioning device according to one of Claims 1 to 12, **characterized in that** at least two folded-up elbow sections (25, 25a) each having a through-cut (41) are provided on an outer side (44) of the first holding arm (3a).

14. Positioning device according to Claim 13, **characterized in that** a latching pin (6) with an axially fitted spring (8) is provided in at least two through-cuts (41) of the at least two elbow sections (25, 25a) on an outer side of the holding arm (3a).

15. Positioning device according to one of Claims 1 to 14, **characterized in that** at least one row (11) of holes consisting of at least two holes (23) is provided on a side wall (42) of the holding arms (3a, 3b).

16. Positioning device according to Claim 15, **characterized in that** at least one holding rail (9) is provided which is fastened at at least two holes (23) of a lower, middle or upper row (10, 11, 12) of holes.

17. Positioning device according to Claim 16, **characterized in that** the holding rail (9) is produced from plastic.

18. Positioning device according to one of Claims 1 to 17, **characterized in that** an extension piece (30) is integrally formed on both holding arms (3a, 3b).

19. Positioning device according to one of Claims 1 to 18, **characterized in that** a cross section of each holding arm (3a, 3b) is stamped in an s-shaped fashion (24).

20. Positioning device according to Claim 19, **characterized in that** the cross sections of the holding arms (3a, 3b) are designed as mirror images of one another.

21. Method for producing a positioning device (1) for positioning a sample (36) with reference to a test means (50) having a cross strut (2), having two pivot bearings (5a, 5b) for the cross strut (2) on which two holders (7a, 7b) are fixed, and having two holding arms (3a, 3b) for the sample (36), **characterized in that** the holding arms (3a, 3b) consist of a bent sheet-metal part (38), and **in that** various positions of the holding arms (3a, 3b) are provided with reference to a fastening device (21) for the pivot bearings (5a, 5b), **in that** the cross strut (2) is fixed on both pivot bearings (5a, 5b), and **in that** the holding arms (3a, 3b) have at least one cutout (14, 15), and **in that** the cross strut (2) pushed into the at least one cutout (14, 15) is fixed on both pivot bearings (5, 5a) by clamping means, and **in that** the two holding arms (3, 3a) and the two holders (7a, 7b) are fabricated from a raw plate-shaped sheet-metal material by means of CAD and CAM.

22. Method according to Claim 21, **characterized in that** the positioning device (1) has two holders (7a, 7b) fitted on the cross strut (2), and **in that** the holding arms (3a, 3b) and the holders (7a, 7b) of the positioning device (1) are produced from a plate-shaped complete part (28), which results from being cut out of the raw plate-shaped sheet-metal material, and are initially still connected to the holding arms (3a, 3b) at separation points (29).

23. Method according to Claim 22, **characterized in that** holes are stamped or drilled into the plate-shaped complete part (28).

24. Method according to Claim 23, **characterized in that** the plate-shaped complete part (28) is dismantled into the individual parts of the positioning device (1) at the separation points (29) provided, the separation being performed without burrs at the separation points (29).

25. Method according to Claim 24, **characterized in that** the individual parts of the positioning device (1) are folded up into their final form.

26. Method according to Claim 25, **characterized in that** in each case at least one holding rail (9) is fastened at at least two holes, lying in a row, of the side wall (42) on the inner side (43) of in each case one holding arm (3a, 3b).

27. Method according to Claim 26, **characterized in that** at least two holders (7a, 7b) to be spaced apart variably are pushed onto the fabricated cross strut (2).

28. Method according to Claim 27, **characterized in that** the cross strut (2) is pushed through the cutouts (14, 15) provided on the holding arms (3a, 3b) and the connecting plate (27) and are clamped in the region of the pivot bearings (5a, 5b) with the aid of clamping screws (34).

## Revendications

1. Dispositif de positionnement (1) destiné à positionner une éprouvette ou un échantillon à contrôler ou tester (36) par rapport à un moyen de contrôle ou de test (50), comprenant une traverse (2), deux systèmes de paliers de rotation (5a, 5b) pour la traverse (2), et deux bras récepteurs (3a, 3b) destinés à recevoir l'échantillon à tester (36),
**caractérisé**
**en ce que** les bras récepteurs (3a, 3b) sont constitués par une pièce de tôle pliée (38) et que sont prévues différentes positions des bras récepteurs (3a, 3b) par rapport à un dispositif de fixation (21) pour les systèmes de paliers de rotation (5a, 5b),
**en ce que** la traverse (2) est fixée aux deux systèmes de palier de rotation (5a, 5b), et
**en ce que** les bras récepteurs (3a, 3b) présentent au moins un évidement de passage (14, 15) et que la traverse (2) insérée dans ledit au moins un évidement de passage (14, 15) est fixée aux deux systèmes de palier de rotation (5a, 5b) par des moyens de serrage.

2. Dispositif de positionnement selon la revendication 1,
**caractérisé**
**en ce que** les moyens de serrage sont des vis de serrage (34).

3. Dispositif de positionnement selon les revendications 1 ou 2,
**caractérisé**
**en ce que** la traverse (2) est massive.

4. Dispositif de positionnement selon la revendication 1 ou la revendication 2,
**caractérisé**
**en ce que** la traverse (2) est réalisée sous forme de profilé creux.

5. Dispositif de positionnement selon l'une des revendications 1 à 4,
**caractérisé**
**en ce qu'**entre chaque bras récepteur (3a, 3b) et la traverse (2) est prévue respectivement une tôle de renfort (26).

6. Dispositif de positionnement selon la revendication 5,
**caractérisé**
**en ce que** la tôle de renfort (26) est d'une configuration en forme de triangle entre respectivement un bras récepteur (3a, 3b) et la traverse (2), un premier évidement de passage (14) pour la réception de la traverse (2) étant prévu à une première extrémité (39) de la tôle de renfort (26) de forme triangulaire.

7. Dispositif de positionnement selon la revendication 5,
**caractérisé**
**en ce qu'**à une deuxième extrémité (40) de la tôle de renfort (26) de forme triangulaire, est prévu un deuxième évidement de passage (15) pour la réception de la traverse (2).

8. Dispositif de positionnement selon la revendication 6 et la revendication 7,
**caractérisé**
**en ce que** sur les deux évidements de passage (14, 15) est prévu respectivement un petit biseau (45).

9. Dispositif de positionnement selon l'une des revendications 1 à 8,
**caractérisé**
**en ce qu'**entre les deux systèmes de palier de rotation (5a, 5b) sont prévus deux supports de maintien (7a, 7b) fixés sur la traverse (2).

10. Dispositif de positionnement selon la revendication 9,
**caractérisé**
**en ce que** la distance d'espacement (18) des supports de maintien (7a, 7b) est variable.

11. Dispositif de positionnement selon l'une des revendications 1 à 10,
**caractérisé**
**en ce que** sur au moins un système de palier de rotation (5a) sont prévues au moins deux rainures d'encliquetage (4) avec une dent d'encliquetage (16) agencée entre deux rainures d'encliquetage (4).

12. Dispositif de positionnement selon la revendication 11,
**caractérisé**
**en ce qu'**une dent d'encliquetage (16) est plus large à son extrémité (32) radialement extérieure qu'à son extrémité (33) radialement intérieure.

13. Dispositif de positionnement selon l'une des revendications 1 à 12,
**caractérisé**
**en ce que** sur un côté extérieur (44) du premier bras récepteur (3a) sont prévues au moins deux pièces coudées (25a, 25b) avec chacune un orifice de passage (41).

14. Dispositif de positionnement selon la revendication 13,
**caractérisé**
**en ce qu'**il est prévu un cliquet d'encliquetage (6) avec un ressort (8) agencé axialement dans au moins deux orifices de passage (41) des dites au moins deux pièces coudées (25a, 25b), sur un côté extérieur du bras récepteur (3a).

15. Dispositif de positionnement selon l'une des revendications 1 à 14,
**caractérisé**
**en ce que** sur une paroi latérale (42) des bras récepteurs (3a, 3b) est prévue au moins une rangée de trous (11) constituée d'au moins deux trous (23).

16. Dispositif de positionnement selon la revendication 15,
**caractérisé**
**en ce qu'**il est prévu au moins un rail récepteur (9) fixé à au moins deux trous (23) d'une rangée de trous (10, 11, 12) inférieure, médiane ou supérieure.

17. Dispositif de positionnement selon la revendication 16,
**caractérisé**
**en ce que** le rail récepteur (9) est réalisé en matière plastique.

18. Dispositif de positionnement selon l'une des revendications 1 à 17,
**caractérisé**
**en ce que** sur les deux bras récepteurs (3a, 3b) est formée une pièce de prolongement (30).

19. Dispositif de positionnement selon l'une des revendications 1 à 18,
**caractérisé**
**en ce qu'**une section transversale de chaque bras récepteur (3a, 3b) est d'une configuration en forme de S (24).

20. Dispositif de positionnement selon la revendication 19,
**caractérisé**
**en ce que** les sections transversales des bras récepteurs (3a, 3b) sont d'une configuration symétrique inverse l'une par rapport à l'autre.

21. Procédé pour la fabrication d'un dispositif de positionnement (1) destiné à positionner une éprouvette ou un échantillon à contrôler ou tester (36) par rapport à un moyen de contrôle ou de test (50), comprenant une traverse (2), deux systèmes de paliers de rotation (5a, 5b) pour la traverse (2) sur laquelle sont fixés deux supports de maintien (7a, 7b), et deux bras récepteurs (3a, 3b) destinés à recevoir l'échantillon à tester (36),
**caractérisé**
**en ce que** les bras récepteurs (3a, 3b) sont constitués par une pièce de tôle pliée (38) et que sont prévues différentes positions des bras récepteurs (3a, 3b) par rapport à un dispositif de fixation (21) pour les systèmes de paliers de rotation (5a, 5b),
**en ce que** l'on fixe la traverse (2) aux deux systèmes de palier de rotation (5a, 5b), et
**en ce que** les bras récepteurs (3a, 3b) présentent au moins un évidement de passage (14, 15), et
**en ce que** l'on fixe la traverse (2) insérée dans ledit au moins un évidement de passage (14, 15) aux deux systèmes de palier de rotation (5a, 5b) par des moyens de serrage, et
**en ce que** les deux bras récepteurs (3a, 3b) et les deux supports de maintien (7a, 7b) sont fabriqués à partir d'un matériau brut de tôle en forme de plaque, selon un processus de conception et de fabrication assistées par ordinateur CAO et FAO .

22. Procédé selon la revendication 21,
**caractérisé**
**en ce que** le dispositif de positionnement (1) présente deux supports de maintien (7a, 7b) agencés sur la traverse (2),
**en ce que** les bras récepteurs (3a, 3b) et les supports de maintien (7a, 7b) du dispositif de positionnement (1) sont fabriqués à partir d'une pièce d'ensemble (28) en forme de plaque, qui est obtenue par découpe dans le matériau brut de tôle en forme de plaque, et les supports de maintien étant tout d'abord encore reliés aux bras récepteurs (3a, 3b) au niveau de zones de sectionnement (29).

23. Procédé selon la revendication 22,
**caractérisé**
**en ce que** l'on réalise des trous, par perçage ou matriçage, dans la pièce d'ensemble (28) en forme de plaque.

24. Procédé selon la revendication 23,
**caractérisé**
**en ce que** l'on subdivise la pièce d'ensemble (28) en les pièces individuelles du dispositif de positionnement (1) au niveau des zones de sectionnement (29) prévues, le sectionnement au niveau des zones de sectionnement (29) étant effectué sans bavures.

25. Procédé selon la revendication 24,
**caractérisé**
**en ce que** l'on plie les pièces individuelles du dispositif de positionnement (1) pour les amener à leur forme définitive.

26. Procédé selon la revendication 25,
**caractérisé**
**en ce que** l'on fixe respectivement au moins un rail récepteur (9) à au moins deux trous situés dans une même rangée, de la paroi latérale (42) sur le côté intérieur (43) d'un bras récepteur (3a, 3b) respectif.

27. Procédé selon la revendication 26,
**caractérisé**
**en ce que** l'on fait glisser sur la traverse (2) finie, au moins deux supports de maintien (7a, 7b) à espacer de manière variable.

28. Procédé selon la revendication 27,
**caractérisé**
**en ce que** l'on fait coulisser la traverse (2) à travers les évidements de passage (14, 15) réalisés sur les bras récepteurs (3a, 3b) et la tôle de liaison (27), et on la serre à l'aide de vis de serrage (34) dans la zone des systèmes de paliers de rotation (5a, 5b).
